# EUROPEAN PATENT SPECIFICATION

(11) **EP 3 784 013 B1**
(45) Date of publication and mention of the grant of the patent: **19.08.2026**
(21) Application number: 18915239.0
(22) Date of filing: 18.04.2018
(51) Int. Cl.: H05K 13/00, B23Q 1/00, B23Q 1/01, F16F 7/10, F16F 15/02

(54) **WORK MACHINE**
ARBEITSMASCHINE
MACHINE DE TRAVAIL

(43) Date of publication of application: 24.02.2021
(73) Proprietor: Fuji Corporation, Chiryu-shi, Aichi 472-8686 (JP)
(72) Inventor: SAKURAYAMA Takeshi, Chiryu-shi, Aichi 472-8686 (JP)
(74) Representative: Grünecker Patent- und Rechtsanwälte PartG mbB
(86) International application number: PCT/JP2018/015974
(87) International publication number: WO 2019/202680

(56) References cited:
- EP-A1- 0 932 331
- EP-A2- 0 767 320
- WO-A1-00/47913
- GB-A- 2 328 263
- JP-A- 2004 293 034
- JP-A- 2010 171 280
- JP-A- 2012 054 497
- JP-A- 2012 122 600
- JP-A- H10 184 783
- JP-U- S59 132 736
- US-B1- 6 382 900

## Description

### Technical Field

The technology disclosed herein relates to a work machine.

### Background Art

Patent Literature 1 discloses a component mounting device. The component mounting device of Patent Literature 1 includes a dynamic vibration absorber that absorbs vibrations of the component mounting device. The dynamic vibration absorber of Patent Literature 1 has a spring member and a damping member, the dynamic vibration absorber having one end that is free and the other end, being fixed, is a cantilever structure.
Patent Literature 2 discloses a supporting apparatus to be placed between a component mounter and a floor in order to dampen transmission of vibrations between the component mounter and the floor. Patent Literature 3 discloses dampers that are urged together by springs for holding and transporting lead frames. Patent Literature 4 discloses a vibration isolator for preventing vibrations generated by a vibration generator in a stick feeder from being transmitted to a base member. Patent Literature 5 discloses an electronic component mounting apparatus wherein the transmission of vibrations from a moving mounting head to the floor is reduced by providing an upper rack on which the mounting head is installed, a lower rack supporting the upper rack, and an anti-vibration mechanism located between the upper rack and the lower rack. Patent Literature 6 discloses a damping device for attenuating the vibration of the free end of a positioning arm of a component mounting machine. The damping device is a hydraulic vibration damper comprising a hollow cylinder filled with oil and a ball that can move freely within the cylinder.

### Patent Literature

Patent Literature 1: JP-A-2007-027533
Patent Literature 2: EP 0 932 331 A1
Patent Literature 3: US 6 382 900 B1
Patent Literature 4: JP 2010 171280 A
Patent Literature 5: JP 2012 054497 A
Patent Literature 6: WO 00/47913 A1

### Summary of the Invention

### Technical Problem

In the component mounting device of Patent Literature 1, the dynamic vibration absorber, having a cantilever structure, may change the appearance of the component mounting device due to being attached at a predetermined position. The present specification provides technology for absorbing vibration without changing the appearance.

### Solution to Problem

The work machine according to the invention is set out in the appended claims.

With such a configuration, there is no change in appearance of the work machine since multiple dampers are accommodated in a space formed in a portion of a main body section of the work machine or in a lower section. Further, since each damper is provided with an outer portion and an inner portion, even if the main body section vibrates, the vibration is absorbed by the outer portion and the inner portion operating in a concerted manner. As a result, the vibration is absorbed without changing the appearance.

### Brief Description of Drawings

[Fig. 1] A diagram showing a schematic configuration of a component mounting device of the embodiment.
[Fig. 2] A perspective view showing a disassembled portion of a damper.

### Description of Embodiments

A work machine according to an embodiment of the invention will be described. The work machine of the embodiment is a component mounting device. The component mounting device is a device for mounting multiple electronic components on a circuit board. The component mounting device is also referred to as a surface mounting device or a chip mounter. Normally, the component mounting device is disposed together with a solder printing device, other component mounting devices, and a board inspection device to form a mounting line.

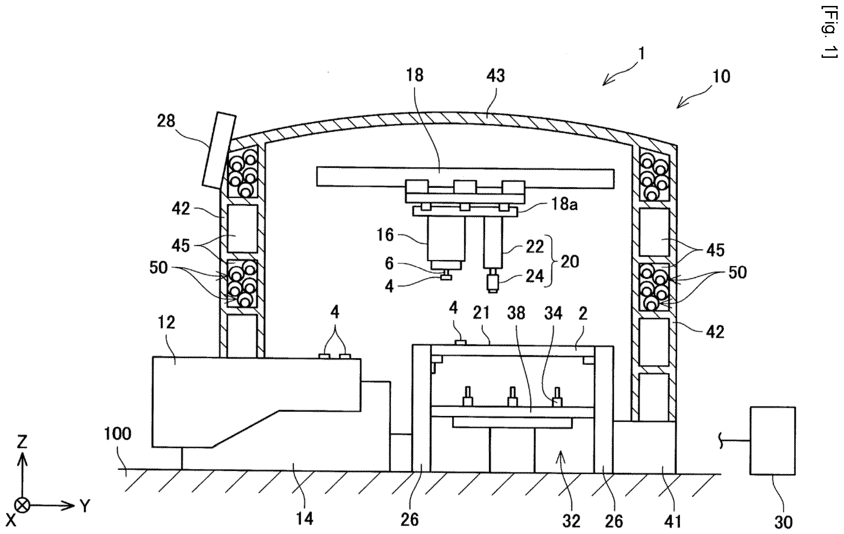

As shown in Fig. 1, component mounting device 1 includes main body section 10 and control section 30. Main body section 10 includes multiple component feeders 12 (Fig. 1 shows one typical component feeder 12), feeder holding section 14, mounting head 16, imaging unit 20, moving mechanism 18 for moving mounting head 16 and imaging unit 20, conveyance device 26, and operation panel 28. Main body section 10 includes base 41 (an example of a lower section), support section 42, and hood 43 (an example of an upper section).

Each component feeder 12 accommodates multiple electronic components 4. Each component feeder 12 is a device for supplying multiple electronic components 4 to be mounted on circuit board 2. Each component feeder 12 is detachably attached to feeder holding section 14 and supplies electronic component 4 to mounting head 16. Each component feeder 12 is, for example, a tape-type feeder for accommodating multiple electronic components 4 in a wound tape form. Each component feeder 12 can supply electronic components 4 by feeding a tape in which multiple electronic components 4 are arranged side by side. Each component feeder 12 may be either a tray-type feeder that accommodates multiple electronic components 4 on a tray, or a bulk-type feeder that randomly accommodates multiple electronic components 4 in a container. The specific configuration of component feeder 12 is not particularly limited.

Moving mechanism 18 moves mounting head 16 and imaging unit 20 between component feeder 12 and circuit board 2. Moving mechanism 18 of this embodiment is an XY robot for moving movement base 18a in the X and Y directions. Moving mechanism 18 is constituted by a guide rail for guiding movement base 18a, a moving mechanism for moving movement base 18a along the guide rail, and a motor or the like for driving the moving mechanism. Moving mechanism 18 is disposed above component feeder 12 and circuit board 2. Mounting head 16 and imaging unit 20 are attached to movement base 18a. Mounting head 16 and imaging unit 20 are moved above component feeder 12 and above circuit board 2 by moving mechanism 18.

Mounting head 16 includes suction nozzle 6 for picking up electronic component 4. Suction nozzle 6 is detachable from mounting head 16. Suction nozzle 6 is installed on mounting head 16 so as to be movable in the Z-direction (i.e., the up-down direction in the drawing). Suction nozzle 6 is configured to ascend and descend in the up-down direction by way of an actuator (not shown) accommodated in mounting head 16 and is configured to pick up electronic component 4. To mount electronic component 4 on circuit board 2 with mounting head 16, moving mechanism 18 first moves mounting head 16 to component pickup position. Next, suction nozzle 6 is moved downward until the lower surface of suction nozzle 6 (i.e., the suction surface) comes in contact with electronic component 4 accommodated in component feeder 12. Next, electronic component 4 is picked up by suction nozzle 6, and suction nozzle 6 is moved upward. Mounting head 16 is then moved to the component mounting position by moving mechanism 18 and positioned with respect to circuit board 2. Then, by lowering suction nozzle 6 toward circuit board 2, electronic component 4 is mounted on circuit board 2.

Imaging unit 20 is attached to movement base 18a. Therefore, when mounting head 16 moves, imaging unit 20 also moves in an integral manner. Imaging unit 20 includes camera support 22 and camera 24. Camera support 22 is attached to movement base 18a. Camera 24 is attached to camera support 22.

Camera 24 is a device for imaging surface 21 of circuit board 2. When imaging unit 20 is moved to a position above circuit board 2 by moving mechanism 18 (i.e., the Z-direction in the drawing), camera 24 is disposed above circuit board 2. Camera 24 images surface 21 of circuit board 2 with the entire surface 21 of circuit board 2 within the imaging range from above circuit board 2. Image data of surface 21 of circuit board 2 captured by camera 24 is transmitted to control section 30. Camera 24 includes a camera control section (not shown) for controlling the operation of camera 24. The operation of camera 24 is controlled by the camera control section.

Conveyance device 26 is a device for conveying in circuit board 2 into component mounting device 1, conveying and positioning circuit board 2 to the component mounting position, and conveying out circuit board 2 from component mounting device 1. Conveyance device 26 may comprise, for example, a pair of belt conveyors, supporting device 32 installed on the belt conveyors and supporting circuit board 2 from below, and a driving device for driving the belt conveyors. Circuit board 2 is conveyed in the X-direction of the drawing.

Supporting device 32 includes support table 38 and multiple support pins 34. Support table 38 and multiple support pins 34 are disposed below circuit board 2. Support table 38 is configured to move up and down. Multiple support pins 34 are fixed to support table 38 and protrude upward. In supporting device 32, when circuit board 2 is conveyed by the belt conveyors to a predetermined work position, support table 38 disposed below circuit board 2 rises. As a result of support table 38 rising, multiple support pins 34 fixed to support table 38 lift circuit board 2 upward.

Base 41 of main body section 10 is disposed on floor 100 of a factory or the like. Feeder holding section 14 and conveyance device 26 are fixed on base 41. Support section 42 is fixed on base 41.

Support section 42 is disposed between base 41 and hood 43. Support section 42 supports hood 43. Operation panel 28 is fixed on support section 42. Operation panel 28 is an input device for receiving instructions from an operator. Support section 42 has a columnar shape. The inside of columnar support section 42 has multiple spaces 45. Multiple spaces 45 of support section 42 accommodate multiple dampers 50.

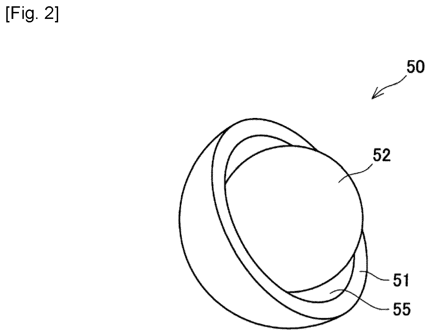

As shown in Fig. 2, each damper 50 includes outer portion 51 and inner portion 52. Outer portion 51 covers inner portion 52. Outer portion 51 is a spherical member. Outer portion 51 is hollow. Inner portion 52 is a spherical member. Inner portion 52 is solid. Inner portion 52 is disposed inside outer portion 51. Inner portion 52 is free to move inside outer portion 51. Space 55 is formed between the inner surface of outer portion 51 and the outer surface of inner portion 52. Each damper 50 has a predetermined weight.

Hood 43 of main body section 10 covers each structure of main body section 10 (i.e., feeder holding section 14, mounting head 16, imaging unit 20, moving mechanism 18, conveyance device 26, and the like). Hood 43 is fixed to support section 42. Hood 43 is disposed above base 41.

Control section 30 of component mounting device 1 includes a computer having a CPU, ROM, and RAM. Although not shown, component feeders 12, mounting head 16, moving mechanism 18, and operation panel 28 are communicably connected to control section 30. Control section 30 controls the mounting of electronic components 4 on circuit boards 2 by controlling each of the sections (12, 16, 18, 28, 32, etc.).

In component mounting device 1 described above, component mounting device 1 may vibrate as a result of the operation of moving mechanism 18, mounting head 16, and the like when mounting multiple electronic components 4 on circuit boards 2. When this occurs, multiple dampers 50 accommodated in spaces 45 of support section 42 absorb vibrations in the configuration described above. That is, when component mounting device 1 vibrates, outer portion 51 and inner portion 52 of each damper 50 operate in a concerted manner to absorb the vibrations of component mounting device 1. Further, the vibrations of component mounting device 1 are reduced by each damper 50 functioning as a weight.

Component mounting device 1 of the embodiment has been described above. As apparent from the above description, component mounting device 1 of the embodiment accommodates multiple dampers 50 in spaces 45 formed in support section 42 of main body section 10. Each damper 50 includes hollow outer portion 51 and inner portion 52 disposed within outer portion 51.

With such a configuration, there is no change in appearance of component mounting device 1 since the multiple dampers 50 are only accommodated in spaces 45 of support section 42. Further, in the above-described configuration, even if component mounting device 1 vibrates, the vibrations of component mounting device 1 are absorbed by outer portion 51 and inner portion 52 of each damper 50 operating in a concerted manner. Therefore, it is possible to absorb the vibrations of component mounting device 1 without changing the appearance of component mounting device 1. Further, by damper 50 functioning as a weight, it is possible to reduce the vibrations of component mounting device 1. That is, it is possible to reduce the vibrational amplitude when component mounting device 1 vibrates.

While one embodiment has been described above, specific embodiments are not limited to the above embodiment. For example, in the above embodiment, multiple dampers 50 are accommodated in multiple spaces 45 of support section 42, but the present invention is not limited to this configuration. In another embodiment, multiple dampers 50 may be accommodated in a single space 45 of support section 42.

In the above embodiment, spaces 45 for accommodating multiple dampers 50 are formed in support section 42, but the present invention is not limited to this configuration. In another embodiment, a single space (not shown) is formed in base 41, and multiple dampers 50 may be accommodated in the space. The position of the space in which multiple dampers 50 are accommodated is not particularly limited. Multiple dampers 50 may be accommodated in any of the spaces formed in a portion of main body section 10 of component mounting device 1.

In the above embodiment, outer portion 51 of each damper 50 has a spherical shape, but the present invention is not limited to this configuration, and for example, outer portion 51 may have a cubic shape. Inner portion 52 of each damper 50 may also have a cubic shape, for example.

In the above embodiment, the work machine was a component mounting device 1 but is not limited to this configuration, and the work machine may be, for example, another machine tool.

In the above embodiment, base 41 of main body section 10 is an example of a lower section, but the present invention is not limited to this configuration, and for example, feeder holding section 14 may be a lower section. In the above embodiment, hood 43 of main body section 10 is an example of an upper section, but the configuration is not limited to this, and for example, moving mechanism 18 may be an upper section. Further, the configuration of support section 42 is not particularly limited.

### Reference Signs List

1: Component mounting device, 2: Circuit board, 4: Electronic component, 6: Suction nozzle, 10: Main body section, 12: Component feeder, 14: Feeder holding section, 16: Mounting head, 18: Moving mechanism, 18a: Movement base, 20: Imaging unit, 21: Surface, 22: Camera support, 24: Camera, 26: Conveyance device, 28: Operation panel, 30: Control section, 32: Supporting device, 34: Support pin, 38: Support table, 41: Base, 42: Support section, 43: Hood, 45: Space, 50: Damper, 51: Outer portion, 52: Inner portion, 55: Space, 100: Floor

## Claims

1. A work machine (1) having a main body section (10), the work machine (1) comprising:
a space (45) formed in a portion of the main body section (10), in which multiple dampers (50) are accommodated,
wherein each damper (50) comprises a hollow outer portion (51) and an inner portion (52) disposed inside the outer portion (51), and
a space (55) is formed between the inner surface of the outer portion (51) and the outer surface of the inner portion (52),
**characterized in that**
the inner portion (52) is free to move inside the outer portion (51), and
the main body section (10) comprises a columnar support section (42) comprising the space (45) on its inside, or a lower section (41) comprising the space.

2. The work machine (1) of claim 1, wherein the work machine (1) is a component mounting device (1) configured to mount a component (4) on a board (2).

3. The work machine (1) of claim 1 or 2, wherein the outer portion (51) is a hollow spherical member and the inner portion (52) is a solid spherical member.

4. The work machine (1) of any one of claims 1 to 3,
wherein the main body section (10) comprises a lower section (41), an upper section (43) disposed above the lower section (41), and the columnar support section (42), configured to support the upper section (43), disposed between the lower section (41) and the upper section (43), and
wherein the multiple dampers (50) are accommodated in the space (45) on the inside of the columnar support section (43).

## Patentansprüche

1. Arbeitsmaschine (1) mit einem Hauptkörperabschnitt (10), wobei die Arbeitsmaschine (1) umfasst:
einen in einem Abschnitt des Hauptkörperabschnitts (10) ausgebildeten Raum (45), in dem mehrere Dämpfer (50) untergebracht sind,
wobei jeder Dämpfer (50) einen hohlen Außenabschnitt (51) und einen innerhalb des Außenabschnitts (51) angeordneten Innenabschnitt (52) umfasst, und
ein Raum (55) zwischen der Innenfläche des Außenabschnitts (51) und der Außenfläche des Innenabschnitts (52) ausgebildet ist,
**dadurch gekennzeichnet, dass**
der Innenabschnitt (52) innerhalb des Außenabschnitts (51) frei beweglich ist, und
der Hauptkörperabschnitt (10) entweder einen säulenförmigen Stützabschnitt (42) umfasst, der den Raum (45) in seinem Inneren aufweist, oder einen unteren Abschnitt (41), der den Raum aufweist.

2. Arbeitsmaschine (1) nach Anspruch 1, wobei die Arbeitsmaschine (1) eine Bauteilmontagevorrichtung (1) ist, die dazu konfiguriert ist, ein Bauteil (4) auf einer Leiterplatte (2) zu montieren.

3. Arbeitsmaschine (1) nach Anspruch 1 oder 2, wobei der Außenabschnitt (51) ein hohles kugelförmiges Element und der Innenabschnitt (52) ein massives kugelförmiges Element ist.

4. Arbeitsmaschine (1) nach einem der Ansprüche 1 bis 3,
wobei der Hauptkörperabschnitt (10) einen unteren Abschnitt (41), einen oberhalb des unteren Abschnitts (41) angeordneten oberen Abschnitt (43) sowie den säulenförmigen Stützabschnitt (42) umfasst, der zum Tragen des oberen Abschnitts (43) ausgebildet ist und zwischen dem unteren Abschnitt (41) und dem oberen Abschnitt (43) angeordnet ist, und
wobei die mehreren Dämpfer (50) in einem Raum (45) an der Innenseite des säulenförmigen Stützabschnitts (43) untergebracht sind.

## Revendications

1. Machine de travail (1) ayant une section de corps principal (10), la machine de travail (1) comprenant :
un espace (45) formé dans une partie de la section de corps principal (10), dans lequel sont logés plusieurs amortisseurs (50),
dans lequel chaque amortisseur (50) comprend une partie extérieure (51) creuse et une partie intérieure (52) disposée à l'intérieur de la partie extérieure (51), et
un espace (55) est formé entre la surface intérieure de la partie extérieure (51) et la surface extérieure de la partie intérieure (52),
**caractérisée en ce que**
la partie intérieure (52) est libre de se déplacer à l'intérieur de la partie extérieure (51), et
la section de corps principal (10) comprend une section de support colonnaire (42) comprenant l'espace (45) à l'intérieur de celle-ci, ou une section inférieure (41) comprenant ledit espace.

2. Machine de travail (1) selon la revendication 1, dans lequel la machine de travail (1) est un dispositif de montage de composants (1) configuré pour monter un composant (4) sur une carte (2).
*

3. Machine de travail (1) selon la revendication 1 ou 2, dans lequel la partie extérieure (51) est un élément sphérique creux et la partie intérieure (52) est un élément sphérique plein.

4. Machine de travail (1) selon l'une quelconque des revendications 1 à 3,
dans lequel la section de corps principal (10) comprend une section inférieure (41), une section supérieure (43) disposée au-dessus de la section inférieure (41), et la section de support colonnaire (42), configurée pour supporter la partie supérieure (43), disposée entre la section inférieure (41) et la partie supérieure (43), et
dans lequel les plusieurs amortisseurs (50) sont logés dans l'espace (45) à l'intérieur de la partie de support colonnaire (43).
